# EUROPÄISCHE PATENTSCHRIFT

(11) **EP 3 396 227 B1**
(45) Veröffentlichungstag und Bekanntmachung des Hinweises auf die Patenterteilung: **04.05.2022**
(21) Anmeldenummer: 17167809.7
(22) Anmeldetag: 24.04.2017
(51) Int. Cl.: F16P 3/08, H03K 17/97

(54) **SICHERHEITSEINRICHTUNG**
SAFETY DEVICE
DISPOSITIF DE SÉCURITÉ

(43) Veröffentlichungstag der Anmeldung: 31.10.2018
(73) Patentinhaber: EUCHNER GmbH + Co. KG, 70771 Leinfelden-Echterdingen (DE)
(72) Erfinder: Mailänder, Joachim, 70199 Stuttgart (DE); Albrecht, Sören, 70563 Stuttgart (DE); Kraus, Matthias, 73760 Ostfildern (DE); Grimm, Ilo, 71111 Waldenbuch (DE)
(74) Vertreter: Ruckh, Rainer Gerhard

(56) Entgegenhaltungen:
- EP-A1- 3 009 956
- DE-A1- 10 216 225
- DE-A1-102008 060 004
- DE-A1-102013 014 456
- DE-A1-102013 019 151

## Beschreibung

Die Erfindung betrifft eine Sicherheitseinrichtung.

Derartige Sicherheitseinrichtungen umfassen einen Sicherheitsschalter und einen relativ zum Sicherheitsschalter beweglich angeordneten Betätiger. Die so ausgebildete Sicherheitseinrichtung wird allgemein im Bereich der Sicherheitstechnik eingesetzt. Ein Beispiel für einen derartigen Einsatz im Bereich der Sicherheitstechnik ist eine Zugangsabsicherung zu einem Gefahrenbereich, wobei der Zugang mit einer Schutztür verschlossen werden kann. In diesem Fall ist der Betätiger typischerweise an der Schutztür angeordnet, während der Sicherheitsschalter an einer den Zugang begrenzenden Rahmenkonstruktion angeordnet ist. Bekannte Sicherheitsschalter weisen ein RFID-System mit einem im Betätiger integrierten Transponder und einer im Sicherheitsschalter integrierten Leseeinheit auf. Mit diesem RFID-System kann die Schließstellung der Schutztür kontrolliert werden. Nur wenn sich die Tür in der Schließstellung befindet, ist der Transponder im Betätiger der Leseeinheit im Sicherheitsschalter räumlich so zugeordnet, dass Transpondersignale des Transponders von der Leseeinheit empfangen werden.

Darüber hinaus kann mit der Sicherheitseinrichtung die Schutztür in ihrer Schließstellung gesichert werden. Hierzu weist der Sicherheitsschalter typischerweise ein Zuhalteelement in Form eines Zuhaltebolzens auf, der dann, wenn sich die Schutztür in der Schließstellung befindet, in eine Aufnahme, insbesondere Ausnehmung im Betätiger, eingefahren werden kann, wodurch eine Zuhaltung der Schutztür bewirkt ist.

Der Sicherheitsschalter generiert ein Freigabesignal für den Betrieb einer Anlage im Gefahrenbereich nur dann, wenn bei bewirkter Zuhaltung auch die Schließstellung des Betätigers durch Erfassung der Signale des Transponders in der Leseeinheit erkannt wird, ansonsten wird im Sicherheitsschalter ein Abschaltbefehl für die Anlage generiert.

Aufgrund von Vibrationen oder anderen mechanischen Störeinflüssen kann sich der Betätiger auch bei bewirkter Zuhaltung relativ zum Sicherheitsschalter bewegen. Um so zu gewährleisten, dass auch bei derartigen Bewegungen die Signale des Transponders noch von der Leseeinheit erkannt werden und damit die Position des Betätigers als in der Schließstellung anwesend erkannt wird, ist der Ansprechbereich der Leseeinheit, innerhalb dessen die Signale des Transponders von der Leseeinheit erkannt werden, hinreichend groß gewählt. Dies kann jedoch dazu führen, dass bei nicht bewirkter Zuhaltung von dem Sicherheitsschalter bereits eine Schließstellung als erkannt gemeldet wird, wenn sich der Betätiger erst dem Sicherheitsschalter annähert und noch nicht in der Schließstellung befindet. In diesem Fall wird ein Versuch, die Zuhaltung zu bewirken fehlschlagen, da das Zuhalteelement noch nicht in die Aufnahme einführbar ist. Dadurch ist die Funktionssicherheit der Sicherheitseinrichtung beeinträchtigt.

Die DE 10 2013 014 456 A1 betrifft einen Betätiger eines Sicherheitsschalters zum Detektieren und Arretieren eines vorgebbaren Zustandes einer Einrichtung, insbesondere zum Detektieren und Arretieren des geschlossenen Zustandes einer Schutzeinrichtung einer Maschine oder dergleichen. Der Betätiger weist eine Induktivität zum kontaktlosen Signalaustausch mit einer Leseinduktivität eines Schalterelements des Sicherheitsschalters auf. Der Betätiger weist eine Sperrflanke auf, an welche ein Sperrelement des Schalterelements in sperrende Anlage bringbar ist und dadurch der Betätiger an dem Schalterelement arretierbar ist. Die Induktivität weist mindestens eine sich um die Sperrflanke oder um eine die Sperrflanke bildende Aussparung oder Bohrung in dem Betätiger herum erstreckende Windung auf, so dass in dem den Betätiger an dem Schalterelement arretierenden Zustand die mindestens eine Windung sich um das Sperrelement oder um eine Verlängerung des Sperrelements herum erstreckt.

Die DE 10 2013 019 151 A1 betrifft eine Vorrichtung zum lösbaren Arretieren und Signalisieren eines vorgebbaren Zustandes einer Schutzeinrichtung einer Maschine oder dergleichen, insbesondere Sicherheitsschalter. Die Vorrichtung weist eine Betätigeraufnahme auf zum Aufnehmen eines an der Schutzeinrichtung festlegbaren Betätigers, wobei die Betätigeraufnahme ein erstes Signalmittel aufweist, das in dem arretierten Zustand der Einrichtung drahtlos in Wirkverbindung mit einem zweiten Signalmittel des Betätigers ist und dadurch der arretierte Zustand für die Vorrichtung detektierbar und signalisierbar ist. Die Vorrichtung weist ein Antriebsmittel auf, durch welches der Betätiger unter Beibehaltung des arretierten Zustandes der Schutzeinrichtung relativ zur Betätigeraufnahme bewegbar ist. Die Vorrichtung ermittelt, ob eine der Relativbewegung entsprechende Veränderung des die Wirkverbindung zwischen dem ersten Signalmittel der Betätigeraufnahme und dem zweiten Signalmittel des Betätigers repräsentierenden Signals feststellbar ist.

Der Erfindung liegt die Aufgabe zugrunde, eine Sicherheitseinrichtung der eingangs genannten Art bereitzustellen, welche eine hohe Funktionssicherheit aufweist.

Zur Lösung dieser Aufgabe sind die Merkmale des Anspruchs 1 vorgesehen. Vorteilhafte Ausführungsformen und zweckmäßige Weiterbildungen sind in den abhängigen Ansprüchen beschrieben.

Die Erfindung betrifft eine Sicherheitseinrichtung mit einem Sicherheitsschalter, welcher eine Leseeinheit und ein Zuhalteelement aufweist und umfasst einen Betätiger, welcher einen Transponder und eine Aufnahme aufweist. In einer mittels der Leseeinheit und des Transponders kontrollierten Schließstellung des Betätigers ist das Zuhalteelement in die Aufnahme einführbar, wodurch eine Zuhaltung möglich ist. Nur innerhalb eines Ansprechbereichs der Leseeinheit werden von dieser Signale des Transponders erfasst. Weiterhin sind Einstellmittel vorgesehen, mittels derer die Größe des Ansprechbereichs abhängig davon vorgegeben ist, ob die Zuhaltung bewirkt ist oder nicht.

Der Grundgedanke der Erfindung besteht somit darin, den Ansprechbereich der Leseeinheit variabel auszubilden, und zwar derart, dass sich die Größe des Ansprechbereichs bei bewirkter Zuhaltung von der Größe des Ansprechbereichs bei nicht bewirkter Zuhaltung unterscheidet.

Erfindungsgemäß ist der Ansprechbereich der Leseeinheit bei nicht bewirkter Zuhaltung kleiner als der Ansprechbereich der Leseeinheit bei bewirkter Zuhaltung.

Dabei ist bei nicht bewirkter Zuhaltung der Ansprechbereich derart reduziert, dass die Leseeinheit Signale des Transponders nur dann erfasst, wenn die Aufnahme dem Zuhalteelement derart räumlich zugeordnet ist, dass das Zuhalteelement in die Aufnahme eingeführt werden kann.

Damit wird auf konstruktiv einfache Weise die Funktionssicherheit der erfindungsgemäßen Sicherheitseinrichtung erhöht.

Der Ansprechbereich der Leseeinheit bei nicht bewirkter Zuhaltung ist erfindungsgemäß derart reduziert, dass die Leseeinheit die Signale des Transponders nur dann erfasst, wenn die Aufnahme des Betätigers so relativ zum Zuhalteelement positioniert ist, dass das Zuhalteelement in diese Aufnahme eingeführt werden kann. Durch die Reduzierung des Ansprechbereichs bei nicht bewirkter Zuhaltung wird verhindert, dass der Sicherheitsschalter den Betätiger dann bereits in der Schließstellung meldet, wenn der Betätiger zwar in den Bereich vor dem Sicherheitsschalter eingefahren ist, jedoch die Aufnahme noch nicht dem Zuhalteelement gegenüberliegt, sodass die Zuhaltung durch Einfahren des Zuhalteelements in die Aufnahme nicht bewirkt werden kann. Durch die erfindungsgemäße Reaktion des Ansprechbereichs bei nicht bewirkter Zuhaltung erfolgt damit eine verbesserte Detektion der Schließstellung derart, dass die Schließstellung vom Sicherheitsschalter nur dann als gültig gemeldet wird, wenn auch das Zuhalteelement sicher in die Aufnahme eingefahren werden kann.

Wesentlich bei der erfindungsgemäßen Sicherheitseinrichtung ist, dass sich der Ansprechbereich bei bewirkter Zuhaltung charakteristisch von dem Ansprechbereich bei nicht bewirkter Zuhaltung derart unterscheidet, wobei der Ansprechbereich bei bewirkter Zuhaltung größer ist als der Ansprechbereich bei nicht bewirkter Zuhaltung.

Bei nicht bewirkter Zuhaltung wird durch einen reduzierten Ansprechbereich nur ein enger Bereich von Relativpositionen des Betätigers zu dem Sicherheitsschalter als mögliche Schließstellung ausgewählt, um zu gewährleisten, dass bei einer durch Detektion der Signale des Transponders in der Leseeinheit erhaltenen Schließstellung das Zuhalteelement in jedem Fall in die Aufnahme eingeführt werden kann, sodass ohne Gefahr einer Fehlfunktion die Zuhaltung bewirkt werden kann.

Bei bewirkter Zuhaltung wird dagegen durch den vergrößerten Ansprechbereich der Bereich der Relativpositionen des Betätigers relativ zum Sicherheitsschalter, innerhalb dessen die Leseeinheit die Signale des Transponders noch erfasst, erhöht. Auch dadurch wird die Funktionseinheit der Sicherheitseinrichtung erhöht, da durch Vibrationen oder dergleichen bewirkte Verschiebungen der Transponder nicht aus dem Ansprechbereich herausläuft. Dadurch werden durch derartige Vibrationen keine Fehlfunktionen der Sicherheitseinrichtung derart erhalten, dass der Sicherheitsschalter trotz in der Schließstellung vorhandenem und mit der Zuhaltung gesichertem Betätiger fälschlicherweise meldet, dass sich der Betätiger nicht in der Schließstellung befindet. Damit werden nicht korrekte von der Sicherheitseinrichtung generierte Abschaltbefehle einer Anlage in einem Gefahrenbereich, der mit der Sicherheitseinrichtung gesichert ist, vermieden.

Eine Bewegung des Betätigers relativ zum Sicherheitsschalter bei Vorliegen von Vibrationen oder sonstigen Störeinflüssen ist insbesondere deshalb möglich, da bei bewirkter Zuhaltung das Zuhalteelement in der Aufnahme bewegbar ist. Insbesondere ist die mechanische Abmessung des Zuhalteelements kleiner als die mechanische Abmessung der Aufnahme, sodass das Zuhalteelement mit Spiel in der Aufnahme gelagert ist. Die Größe des Spiels bestimmt im Wesentlichen den Umfang der Bewegungen des Betätigers relativ zum Sicherheitsschalter bei Vorliegen von äußeren Störeinflüssen. Da erfindungsgemäß der Ansprechbereich bei bewirkter Zuhaltung an die Bewegungen angepasst ist, werden Fehlfunktionen der Sicherheitseinrichtung aufgrund dieser Bewegungen vermieden.

Gemäß einer vorteilhaften Ausgestaltung der Erfindung weist die Leseeinheit eine Lesespule zur Erfassung der Signale des Transponders und eine Auswerteeinheit auf, wobei durch eine Schwellwertbewertung der Signale der Lesespule der Ansprechbereich bestimmt ist.

Im einfachsten Fall wird die Schwellwertbestimmung mit nur einem Schwellwert bewertet, der dann die Grenze des Ansprechbereichs definiert. Der Betätiger ist dann in einer Schließstellung erfasst, wenn die Signale des Transponders größer als der Schwellwert sind und damit innerhalb des Ansprechbereichs erfasst sind.

Vorteilhaft wird zur Bildung einer Hysterese ein erster Schwellwert, der einen Einschaltabstand definiert, und ein zweiter Schwellwert, der einen Ausschaltabstand definiert, zur Schwellwertbewertung herangezogen.

Gemäß einer ersten Variante ist mittels der Einstellmittel zur Änderung des Ansprechbereichs wenigstens ein Schwellwert zur Bewertung der Signale der Lesespule einstellbar.

Da der oder die Schwellwerte die Grenzen der Ansprechbereiche definieren, kann durch die Schwellwerteinstellung die Größe des Ansprechbereichs einfach und exakt vorgegeben werden.

Gemäß einer hierzu gleichwertigen, zweiten Variante ist mittels der Einstellmittel zur Änderung des Ansprechbereichs eine Verstärkung der Signale der Lesespule einstellbar.

Da sowohl bei bewirkter Zuhaltung als auch nicht bewirkter Zuhaltung jeweils nur ein definierter Ansprechbereich für die Leseeinheit benötigt wird, können die Einstellmittel besonders vorteilhaft in Form einfacher Umschaltmittel vorgesehen werden, mittels derer zwischen zwei unterschiedlichen Ansprechbereichen umgeschaltet wird.

Besonders vorteilhaft sind die Einstellmittel Bestandteil der Auswerteeinheit, sodass der konstruktive Aufwand für die Einstellmittel gering gehalten werden kann.

Dabei können die Einstellmittel in Form einer Hardwareschaltung ausgebildet sein.

Alternativ sind die Einstellmittel in Form von in der Auswerteeinheit implementierten Softwaremodulen ausgebildet.

Die Erfindung wird im Folgenden anhand der Zeichnungen erläutert. Es zeigen:
- Figur 1:: Ausführungsbeispiel der erfindungsgemäßen Sicherheitseinrichtung mit einem Sicherheitsschalter und einem Betätiger.
- Figur 2:: Schematische Darstellung eines Ansprechbereichs für die Leseeinheit des Sicherheitsschalters gemäß Figur 1 mit den die Ansprechbereiche definierenden Größen.
- Figur 3:: Ansprechbereich für den Sicherheitsschalter gemäß Figur 1 bei nicht bewirkter Zuhaltung.
- Figur 4:: Ansprechbereich für den Sicherheitsschalter gemäß Figur 1 bei bewirkter Zuhaltung.

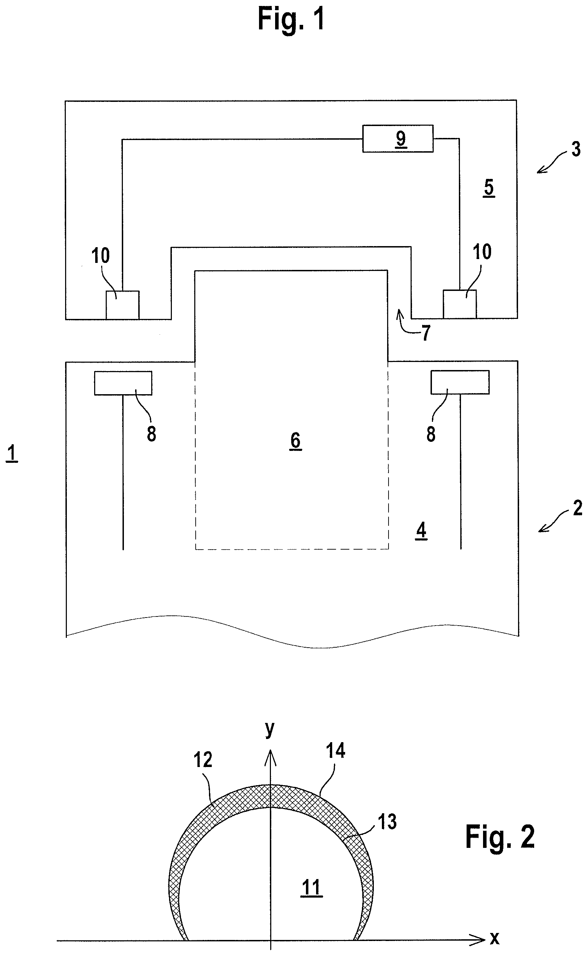

Figur 1 zeigt eine Ausführungsform der erfindungsgemäßen Sicherheitseinrichtung 1, die einen Sicherheitsschalter 2 und einen relativ zum Sicherheitsschalter 2 beweglichen Betätiger 3 aufweist.

Mit dieser Sicherheitseinrichtung 1 erfolgt beispielweise die Sicherung einer Schutztür als Zugang zu einem Gefahrenbereich. Der Betätiger 3 kann dann an der Schutztür angeordnet sein, der Sicherheitsschalter 2 kann an einem die Türöffnung begrenzenden Rahmen angeordnet werden. Im Gefahrenbereich befindet sich eine Anlage, von der Gefahren für Personen ausgehen können.

Mit der Sicherheitseinrichtung 1 wird einerseits die Schließstellung der Schutztür kontrolliert, wobei sich die Schutztür dann in ihrer Schließstellung befindet, wenn der Betätiger 3 in einer entsprechenden Schließstellung am Sicherheitsschalter 2 liegt. Weiterhin wird mit der Sicherheitseinrichtung 1 eine Zuhaltung der Schutztür in ihrer Schließstellung bewirkt.

Figur 1 zeigt den Betätiger 3 in einer Schließstellung, in welcher der Betätiger 3 dem Sicherheitsschalter 2 gegenüberliegt. Diese Schließstellung wird durch ein RFID-System überwacht, das generell eine im Sicherheitsschalter 2 angeordnete Leseinheit 4 und einen im Betätiger 3 angeordneten Transponder 5 aufweist.

Der Sicherheitsschalter 2 weist ein Zuhalteelement 6 in Form eines Zuhaltebolzens auf. Der Betätiger 3 weist korrespondierend hierzu eine Aufnahme 7 in Form einer Ausnehmung auf. Das Zuhalteelement 6 kann mittels eines nicht dargestellten Antriebs in axialer Richtung des Sicherheitsschalters 2 zwischen einer Freigabestellung und einer Sperrstellung verfahren werden. In der Freigabestellung ist das Zuhalteelement 6 komplett in den Sicherheitsschalter 2 eingefahren. Befindet sich der Betätiger 3 in seiner Schließstellung, kann das Zuhalteelement 6, wie in den Figuren 1,3 und 4 dargestellt, in die Sperrstellung ausgefahren werden, sodass das Zuhalteelement 6 in die Aufnahme 7 des Betätigers 3 eingeführt ist, wodurch die Zuhaltung bewirkt wird. Wie Figur 1 zeigt, ist die mechanische Abmessung des Zuhalteelements 6 kleiner als die mechanische Abmessung der Aufnahme 7, sodass das Zuhalteelement 6 mit Spiel in der Aufnahme 7 liegt.

Die Leseeinheit 4 des RFID-Systems weist eine Lesespule 8 im Bereich der dem Betätiger 3 zugewandten Stirnfläche des Sicherheitsschalters 2 auf. Die Lesespule 8 ist an eine nicht dargestellte Auswerteeinheit als weiterem Bestandteil der Leseeinheit 4 angeschlossen.

Der Transponder 5 des Betätigers 3 gemäß Figur 1 weist einen Transponderchip 9 und eine Transponderspule 10 auf, die Bestandteil eines Transponderschwingkreises ist. Der Transponderschwingkreis weist weiterhin einen nicht dargestellten Kondensator auf. Die Transponderspule 10 befindet sich im Bereich der dem Sicherheitsschalter 2 zugewandten Stirnseite des Betätigers 3. Durch den Transponderchip 9 kann eine Kodierung der Signale des Transponders 5 vorgegeben werden.

Wird anhand der in der Leseeinheit 4 erfassten Signale des Transponders 5 der Betätiger 3 in seiner Schließstellung erkannt, und ist die Zuhaltung durch Einfahren des Zuhalteelements 6 in die Aufnahme 7 bewirkt, was mit einer dem Zuhalteelement 6 und der Aufnahme 7 zugeordneten Sensoreinheit kontrolliert werden kann, so wird mittels der Sicherheitseinrichtung 1 ein Freigabesignal generiert, mittels dessen der Betrieb der Anlage freigegeben wird.

Bei nicht bewirkter Zuhaltung oder für den Fall, das bei bewirkter Zuhaltung die Leseeinheit 4 die Signale des Transponders 5 nicht erfasst und somit der Sicherheitsschalter 2 meldet, dass der Betätiger 3 nicht in der Schließstellung ist, wird mittels der Sicherheitseinrichtung 1 ein Abschaltbefehl für die Anlage generiert.

Die Signale des Transponders 5 werden, entsprechend der Ausgestaltung der Lesespule 8, innerhalb eines Ansprechbereichs 11 erkannt, der beispielhaft in Figur 2 in einem Koordinatensystem dargestellt ist. Der Ansprechbereich 11 ist, wie Figur 2 zeigt, von einem Hysteresebereich 12 begrenzt, der durch einen Einschaltabstand 13 und einen Ausschaltabstand 14 begrenzt ist.

Der Einschaltabstand 13 und der Ausschaltabstand 14 sind durch Schwellwerte definiert, mit denen der Pegel der Signale des Transponders 5 bewirkt wird. Die Schwellwerte können in der Software der Auswerteeinheit der Leseeinheit 4 hinterlegt sein. Alternativ kann die Auswerteeinheit eine Hardwarebeschaltung in Form von Komparatoren oder dergleichen zur Vorgabe der Schwellwerte aufweisen.

Wird bei Annähern des Betätigers 3 der Einschaltabstand 13 unterschritten, was dadurch festgestellt wird, dass die mit der Leseeinheit 4 empfangenen Signale des Transponders 5 den den Einschaltabstand 13 definierenden Schwellwert überschreiten, so wird in der Auswerteeinheit ein Signal generiert, mit dem der Betätiger 3 in der Schließstellung gemeldet wird. Wird der Betätiger 3 dann wieder vom Sicherheitsschalter 2 weg bewegt, so wird das den Betätiger 3 in der Schließstellung meldende Signal wieder zurückgenommen, wenn der Ausschaltabstand 14 überschritten wird, was dadurch festgestellt wird, dass die mit der Leseeinheit 4 empfangenen Signale des Transponders 5 den den Ausschaltabstand 14 definierenden Schwellwert unterschreiten.

Mit dieser Auswertung werden somit die Transpondersignale von der Leseeinheit 4 nur innerhalb des Ansprechbereichs 11 erfasst, sodass der Sicherheitsschalter 2 den Betätiger 3 in der Schließstellung nur meldet, wenn die Transpondersignale im Ansprechbereich 11 erfasst werden.

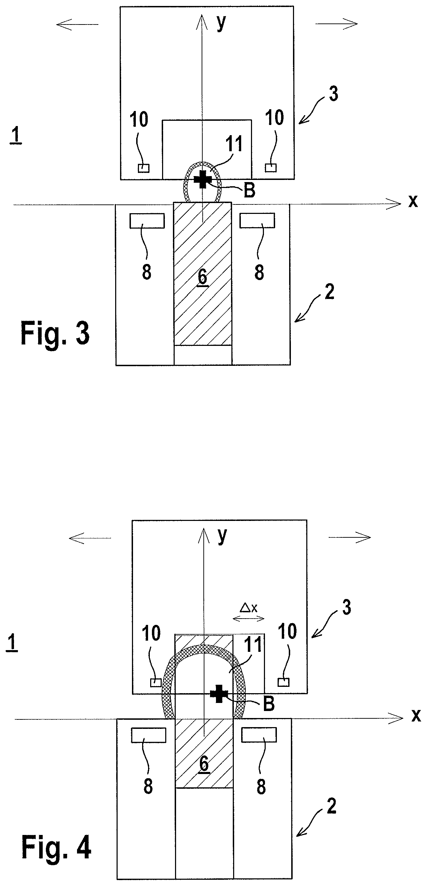

Erfindungsgemäß wird der Ansprechbereich 11 abhängig davon gewählt, ob bei der Sicherheitseinrichtung 1 die Zuhaltung bewirkt ist oder nicht. Die hierfür erforderliche Änderung des Ansprechbereichs 11 erfolgt in der Auswerteeinheit durch eine Änderung der den Einschaltabstand 13 und den Ausschaltabstand 14 definierenden Schwellwerte oder durch eine Veränderung der Verstärkung der in der Leseeinheit 4 empfangenen Signale des Transponders 5. Die erfindungsgemäße Vorgabe des Ansprechbereichs 11 ist in den Figuren 3 und 4 veranschaulicht.

Figur 3 zeigt die Sicherheitseinrichtung 1 bei nicht bewirkter Zuhaltung. Der Betätiger 3 wird in der in positiver oder negativer x-Richtung verlaufenden Verfahrrichtung auf den Sicherheitsschalter 2 zubewegt. In diesem Fall ist der Ansprechbereich 11 so gewählt, dass der Betätiger 3 nur dann mit dem RFID-System in der Schließstellung erkannt wird, wenn das Zuhalteelement 6 der Aufnahme 7 so zugeordnet ist.

In Figur 3 ist als Bezugspunkt der Mittelpunkt der Transponderspule 10 mit B bezeichnet. Liegt dessen Bezugspunkt innerhalb des Ansprechbereichs 11, werden die Signale des Transponders 5 von der Leseeinheit 4 erfasst, da dann die Pegel der Signale des Transponders 5 größer als der den Einschaltabstand 13 definierenden Schwellwert sind. Wie Figur 3 zeigt, ist für jede mögliche Anordnung des Bezugspunkts B im Ansprechbereich 11 gewährleistet, dass die Aufnahme 7 dem Zuhalteelement 6 so gegenüber liegt, dass das Zuhalteelement 6 in die Aufnahme 7 eingefahren werden kann.

Dadurch ist gewährleistet, dass immer dann, wenn eine Schließstellung des Betätigers 3 durch Erfassen der Signale des Transponders 5 in der Leseeinheit 4 erkannt wird, die Zuhaltung durch Einführen des Zuhalteelements 6 in die Aufnahme 7 auch bewirkt werden kann, sodass Fehlfunktionen derart, dass eine Schließstellung des Betätigers 3 gemeldet wird, in der die Zuhaltung nicht bewirkt werden kann, vermieden werden.

Figur 4 zeigt die Sicherheitseinrichtung 1 bei bewirkter Zuhaltung, das heißt für den Fall, dass das Zuhalteelement 6 in die Aufnahme 7 eingeführt ist. In diesem Fall ist der Ansprechbereich 11 gegenüber dem Ansprechbereich 11 bei nicht bewirkter Zuhaltung größer, wie der Vergleich mit Figur 3 zeigt.

Wie aus Figur 4 ersichtlich, kann aufgrund dessen, dass die mechanische Abmessung des Zuhalteelements 6 kleiner ist als der die mechanische Abmessung der Aufnahme 7 das Zuhalteelement 6 innerhalb eines Toleranzbereichs in Verfahrrichtung Δ x in der Aufnahme bewegt werden.

Der Ansprechbereich 11 ist derart definiert, dass unabhängig von der Position des Zuhalteelements 6 in der Aufnahme 7 der Bezugspunkt B der Transponderspule 10 im Ansprechbereich 11 liegt, das heißt die Signale des Transponders 5 werden in der Leseeinheit 4 erfasst.

Damit werden Fehlfunktionen bedingt durch Vibrationen oder andere Störeinflüsse ausgeschlossen. Durch derartige Vibrationen bewegt sich das Zuhalteelement 6 in der Aufnahme 7 und damit der Betätiger 3 relativ zum Sicherheitsschalter 2. Da der Ansprechbereich 11 so groß gewählt ist, dass bei allen möglichen Bewegungen der Bezugspunkt B der Transponderspule 10 immer innerhalb des Ansprechbereichs 11 liegt, werden die Signale des Transponders immer von der Leseeinheit 4 erfasst und der Betätiger 3 in der Schließstellung gemeldet.

Damit werden Fehlfunktionen derart, dass bedingt durch Vibrationen der Sicherheitsschalter 2 den Betätiger 3 nicht mehr in der Schließstellung erkennt, obwohl die Zuhaltung bewirkt ist und damit real eine Schließstellung vorliegt, vermieden und damit auch nicht korrekte Abschaltungen der Anlage im Gefahrenbereich.

### Bezugszeichenliste

- (1): Sicherheitseinrichtung
- (2): Sicherheitsschalter
- (3): Betätiger
- (4): Leseeinheit
- (5): Transponder
- (6): Zuhalteelement
- (7): Aufnahme
- (8): Lesespule
- (9): Transponderchip
- (10): Transponderspule
- (11): Ansprechbereich
- (12): Hysteresebereich
- (13): Einschaltabstand
- (14): Ausschaltabstand

## Patentansprüche

1. Sicherheitseinrichtung (1) mit einem Sicherheitsschalter (2), welcher eine Leseeinheit (4) und ein Zuhalteelement (6) aufweist, und mit einem Betätiger (3), welcher einen Transponder (5) und eine Aufnahme (7) aufweist, wobei in einer mittels der Leseeinheit (4) und des Transponders (5) kontrollierten Schließstellung des Betätigers (3) das Zuhalteelement (6) in die Aufnahme (7) einführbar ist, wodurch eine Zuhaltung bewirkt ist, wobei nur innerhalb eines Ansprechbereichs (11) der Leseeinheit (4) von dieser Signale des Transponders (5) erfasst werden, **dadurch gekennzeichnet, dass** Einstellmittel vorgesehen sind, mittels derer die Größe des Ansprechbereichs (11) abhängig davon vorgegeben ist, ob die Zuhaltung bewirkt ist oder nicht, wobei der Ansprechbereich (11) der Leseeinheit (4) bei nicht bewirkter Zuhaltung kleiner ist als der Ansprechbereich (11) der Leseeinheit (4) bei bewirkter Zuhaltung, und bei nicht bewirkter Zuhaltung der Ansprechbereich (11) derart reduziert ist, dass die Leseeinheit (4) Signale des Transponders (5) nur dann erfasst, wenn die Aufnahme dem Zuhalteelement (6) derart räumlich zugeordnet ist, dass das Zuhalteelement (6) in die Aufnahme (7) eingeführt werden kann, wobei bei bewirkter Zuhaltung das Zuhalteelement (6) innerhalb der Aufnahme (7) bewegbar ist, und dass der Ansprechbereich (11) bei bewirkter Zuhaltung so dimensioniert ist, dass bei diesen Bewegungen der Transponder (5) innerhalb des Ansprechbereichs (11) verbleibt, wobei die Aufnahme (7) eine mechanische Abmessung aufweist, der größer als die mechanische Abmessung des Zuhalteelements (6) ist, sodass das Zuhalteelement (6) bei bewirkter Zuhaltung mit einem Spiel in der Aufnahme (7) gelagert ist, und dass der Ansprechbereich (11) bei bewirkter Zuhaltung an dieses Spiel angepasst ist.

2. Sicherheitseinrichtung (1) nach Anspruch 1 **dadurch gekennzeichnet, dass** die Leseeinheit (4) eine Lesespule (8) zur Erfassung der Signale des Transponders (5) und eine Auswerteeinheit aufweist, wobei durch eine Schwellwertbewertung der Signale der Lesespule (8) der Ansprechbereich (11) bestimmt ist.

3. Sicherheitseinrichtung (1) nach Anspruch 2 **dadurch gekennzeichnet, dass** mittels der Einstellmittel zur Änderung des Ansprechbereichs (11) wenigstens ein Schwellwert zur Bewertung der Signale der Lesespule (8) einstellbar ist.

4. Sicherheitseinrichtung (1) nach Anspruch 2, **dadurch gekennzeichnet, dass** mittels der Einstellmittel zur Änderung des Ansprechbereichs (11) eine Verstärkung der Signale der Lesespule (8) einstellbar ist.

5. Sicherheitseinrichtung (1) nach einem der Ansprüche 2 4, **dadurch gekennzeichnet, dass** die Einstellmittel Bestandteil der Auswerteeinheit sind.

6. Sicherheitseinrichtung (1) nach einem der Ansprüche 1 - 5 , **dadurch gekennzeichnet, dass** die Einstellmittel als Umschaltmittel ausgebildet sind.

7. Sicherheitseinrichtung (1) nach einem der Ansprüche 1 - 6 , **dadurch gekennzeichnet, dass** die Einstellmittel in Form einer Hardwareschaltung ausgebildet sind.

8. Sicherheitseinrichtung nach einem der Ansprüche 1 - 7 , **dadurch gekennzeichnet, dass** die Einstellmittel in Form von in der Auswerteeinheit implementierten Softwaremodulen ausgebildet sind.

## Claims

1. Safety device (1) with a safety switch (2), which comprises a reader unit (4) and a retaining element (6), and with an actuator (3), which comprises a transponder (5) and a receptacle (7), wherein in a closed setting of the actuator (3) controlled by means of the reader unit (4) and the transponder (5) the retaining element (6) is introducible into the receptacle (7) whereby retention is produced, wherein signals of the transponder (5) are detected by the reader unit (4) only within a response range (11) thereof, **characterised in that** setting means, by way of which the size of the response range (11) is predetermined in dependence on whether or not the retention is produced, are provided, wherein the response range (11) of the reader unit (4) when retention is not produced is smaller than the response range (11) of the reader unit (4) when retention is produced, and when retention is not produced the response range (11) is reduced in such a way that the reader unit (4) detects signals of the transponder (5) only when the receptacle of the retaining unit (6) is physically associated therewith in such a way that the retaining unit (6) can be introduced into the receptacle (7), wherein when retention is produced the retaining element (6) is movable within the receptacle (7) and the response range (11) when retention is produced is so dimensioned that when these movements occur the transponder (5) remains within the response range (11), wherein the receptacle (7) has a mechanical dimensioning which is larger than the mechanical dimensioning of the retaining element (6) so that the retaining element (6) when retention is produced is mounted with play in the receptacle (7), and the response range (11) when retention is produced is adapted to this play.

2. Safety device (1) according to claim 1, **characterised in that** the reader unit (4) comprises a reading coil (8) for detection of the signals of the transponder (5) and an evaluating unit, wherein the response range (11) is determined by a threshold value evaluation of the signals of the reading coil (8).

3. Safety device (1) according to claim 2, **characterised in that** at least one threshold value for evaluation of the signals of the reading coil (8) is settable by way of the setting means for changing the response range (11).

4. Safety device (1) according to claim 2, **characterised in that** amplification of the signals of the reading coil (8) is settable by way of the setting means for change of the response range (11).

5. Safety device (1) according to any one of claims 2 to 4, **characterised in that** the setting means are a component of the evaluating unit.

6. Safety device (1) according to any one of claims 1 to 5, **characterised in that** the setting means are configured as switching-over means.

7. Safety device (1) according to any one of claims 1 to 6, **characterised in that** the setting means are configured in the form of a hardware circuit.

8. Safety device according to any one of claims 1 to 7, **characterised in that** the setting means are configured in the form of software modules implemented in the evaluating unit.

## Revendications

1. Dispositif de sécurité (1) comprenant un interrupteur de sécurité (2) muni d'une unité de lecture (4) et d'un élément (6) de maintien à la fermeture, et un actionneur (3) doté d'un transpondeur (5) et d'un logement (7), ledit élément (6) de maintien à la fermeture pouvant être introduit dans le logement (7), dans une position fermée de l'actionneur (3) contrôlée au moyen de l'unité de lecture (4) et du transpondeur (5), ce qui a pour effet de provoquer un maintien à la fermeture, sachant que des signaux dudit transpondeur (5) sont détectés, par ladite unité de lecture (4), uniquement dans les limites d'une plage de réponses (11) de cette dernière, **caractérisé par** la présence de moyens de réglage à l'aide desquels la grandeur de la plage de réponses (11) est préétablie en fonction de l'instauration ou de la non-instauration du maintien à la fermeture,
sachant
qu'à l'état non instauré du maintien à la fermeture, la plage de réponses (11) de l'unité de lecture (4) est plus petite que la plage de réponses (11) de ladite unité de lecture (4) à l'état instauré du maintien à la fermeture
et
qu'à l'état non instauré dudit maintien à la fermeture, ladite plage de réponses (11) est réduite de telle manière que ladite unité de lecture (4) détecte des signaux du transpondeur (5) uniquement lorsque le logement est associé, dans l'espace, à l'élément (6) de maintien à la fermeture de façon telle que ledit élément (6) de maintien à la fermeture puisse être introduit dans ledit logement (7),
sachant
qu'à l'état instauré du maintien à la fermeture, ledit élément (6) de maintien à la fermeture peut être animé de mouvements à l'intérieur dudit logement (7), et qu'à l'état instauré dudit maintien à la fermeture, la plage de réponses (11) est dimensionnée de telle sorte que le transpondeur (5) demeure dans les limites de ladite plage de réponses (11) lors de ces mouvements,
le logement (7) présentant un dimensionnement mécanique supérieur au dimensionnement mécanique de l'élément (6) de maintien à la fermeture, de façon telle qu'à l'état instauré du maintien à la fermeture, ledit élément (6) de maintien à la fermeture soit disposé avec jeu dans ledit logement (7), et que la plage de réponses (11) soit adaptée à ce jeu à l'état instauré dudit maintien à la fermeture.

2. Dispositif de sécurité (1) selon la revendication 1, **caractérisé par le fait que** l'unité de lecture (4) est dotée d'une unité d'évaluation et d'une bobine de lecture (8) dévolue à la détection des signaux du transpondeur (5), la plage de réponses (11) étant déterminée par une évaluation de valeurs de seuil des signaux de ladite bobine de lecture (8).

3. Dispositif de sécurité (1) selon la revendication 2, **caractérisé par le fait qu'**au moins une valeur de seuil peut être réglée, en vue de l'évaluation des signaux de la bobine de lecture (8), à l'aide des moyens de réglage conçus pour modifier la plage de réponses (11).

4. Dispositif de sécurité (1) selon la revendication 2, **caractérisé par le fait qu'**une amplification des signaux de la bobine de lecture (8) peut être réglée à l'aide des moyens de réglage conçus pour modifier la plage de réponses (11).

5. Dispositif de sécurité (1) selon l'une des revendications 2-4, **caractérisé par le fait que** les moyens de réglage font partie intégrante de l'unité d'évaluation.

6. Dispositif de sécurité (1) selon l'une des revendications 1-5, **caractérisé par le fait que** les moyens de réglage sont réalisés en tant que moyens de commutation.

7. Dispositif de sécurité (1) selon l'une des revendications 1-6, **caractérisé par le fait que** les moyens de réglage sont réalisés sous la forme d'un circuit matériel.

8. Dispositif de sécurité (1) selon l'une des revendications 1-7, **caractérisé par le fait que** les moyens de réglage sont réalisés sous la forme de modules logiciels mis en œuvre dans l'unité d'évaluation.
